# EUROPEAN PATENT SPECIFICATION

(11) **EP 3 096 352 B1**
(45) Date of publication and mention of the grant of the patent: **21.02.2018**
(21) Application number: 15305771.6
(22) Date of filing: 22.05.2015
(51) Int. Cl.: H01L 23/473, F28F 13/12, C09K 5/10, F28D 21/00

(54) **A HEAT TRANSFER METHOD AND DEVICE**
WÄRMEÜBERTRAGUNGSVERFAHREN UND -VORRICHTUNG
PROCÉDÉ ET DISPOSITIF DE TRANSFERT DE CHALEUR

(43) Date of publication of application: 23.11.2016
(73) Proprietor: ALCATEL LUCENT, 92100 Boulogne-Billancourt (FR)
(72) Inventor: NOLAN, Kevin, DUBLIN, 15 (IE); JEFFERS, Nicholas, DUBLIN, 15 (IE); STAFFORD, Jason, DUBLIN, 15 (IE); DONNELLY, Brian, Dublin, 15 (IE)
(74) Representative: Berthier, Karine

(56) References cited:
- US-A1- 2005 092 007
- US-A1- 2011 079 376
- US-B1- 7 990 711
- US-B1- 8 953 314

## Description

### FIELD OF THE INVENTION

The invention relates to the field of heat transfer.

### BACKGROUND

In the field of data processing and wireless communication the amount of data traffic has greatly increased in a limited time. The devices and circuits used in these applications are often heat sensitive and thus, it is important that any temperature rise due to this increase in data traffic is controlled. Many of the current thermal solutions employed today cannot scale to meet future demands. One proposed solution to this problem suggested by Alcatel Lucent is a novel photonics cooling architecture called Thermally Integrated Photonics Systems (TIPS). A key part to this solution is the use of microchannel cooling technologies with enhanced cooling characteristics.

Microchannels typically consist of sub 500µm channels for fluid flow. As the amount of surface area contacted by the fluid increases heat transfer between the fluid and the walls of the channel increases but so too does the resistance to flow experienced by the fluid. The resulting large surface area provided by an array of such conduits allows for enhanced heat transfer and under certain conditions microchannels can remove significant amounts of thermal energy, in particular cooling of thermal fluxes of up to 700 Watts per centimetre squared may be possible. However, owing to the small size of these channels, a significant pumping pressure is required to generate the flow rates necessary to convect the heat from the channel walls.

It would be desirable to be able to increase heat transfer without requiring unduly high pumping pressures.

US2005/0092007 discloses a cooling device for electronic devices having a microconduit with obstructions and a fluid flow rate such that turbulence is generated at the obstructions in the fluid flow to increase heat transfer. Example coolant fluids include water, alcohols and alkanes.

US2011/079376 discloses a cold plate for use cooling an electronic device comprising an enclosure through which the fluid flows which may have shaped pins which act as obstacles to increase surface area and thus, heat transfer and encourage turbulent flow. U87990711 discloses a stack of silicon wafers cooled by a cooling plate through which cooling fluid flows.

US8953314 discloses a cooling system for an electronic device where a cooling fluid flows through a plenum having movable pins which move by capillary flow from areas of higher temperature on the surface to be cooled to areas of lower temperature thereby opening up the areas of higher temperature to fluid flow and increasing heat transfer.

### SUMMARY

A first aspect of the present invention provides a heat transfer device, said heat transfer device comprising: a conduit having at least one mini dimension of less than 1 centimetre; a viscoelastic fluid operable to flow through said conduit and to transfer heat from a heat source in thermal contact with said conduit; said conduit comprising at least one obstruction each arranged at a predetermined location, said obstruction being configured to partially block fluid flow and generate local instabilities in said fluid flow upstream of said obstruction thereby increasing heat transfer from said heat source at a location upstream of said predetermined location.

In order to increase heat transfer provided by a fluid flow, an increased heat transfer surface area and greater turbulence are desirable. However, both of these lead to an increased resistance to flow in the fluid and thus, an increased pumping requirement.

The inventors of the present invention recognised that were it possible to generate local instabilities in a fluid flow then increased local cooling might be provided without an undue increase in pressure requirements owing to much of the flow remaining laminar (i.e. substantially free of instabilities). Controlling such instabilities is not however, straightforward. The inventors recognised that viscoelastic fluids with non-Newtonian properties might provide a solution to this problem.

Viscoelastic fluids generally have a higher viscosity than many Newtonian fluids such as water and may also be less predictable in their properties and behaviour and as such there is a technical prejudice against using such fluids in heat transfer devices. However, owing to the way their viscosity changes with shear, obstructions in a conduit can be used to cause instabilities in the flow path upstream of the obstacle and these patches of unstable flow will increase heat transfer at these locations. The viscosity of the fluid will act to dampen these instabilities and thus, laminar flow will be attained again downstream.

Such fluids could therefore be used to provide local instabilities in a fluid flow, while much of the flow remained laminar. By maintaining laminar flow for much of the flow path the resistance to flow would not be greatly increased, however local instabilities at selected locations would provide a significant increase in heat transfer at these locations. Thus, where a heat source is known to have hot spots such an arrangement is an efficient way of reducing heat locally without unduly increasing required pumping powers.

Although in general the viscosity of such fluids is high, their viscosity decreases with shear and as such in a conduit having a mini dimension their viscosity is not as different from that of a Newtonian fluid as it would be in a conduit with larger dimensions. Providing one dimension as a mini dimension also restricts the size of the heat transfer device thereby enabling cooling without unduly increasing the size of the overall device.

Viscoelastic fluids can be formed from Newtonian fluids such as water by adding a very small amount of another composition such as long chain polymers or surfactants. Such viscoelastic fluids have memory properties and a high Weissenberg number, generally greater than 10. The memory properties arise from the shearing of the fluid, due to flow over a wall for example, stretching the elastic components such as the polymers in the fluid like springs, the energy stored in these components is then released when the flow passes over an obstacle or around a bend instigating mixing at this location. The viscosity of the fluid then acts to damp the mixing and the flow returns to a laminar flow. With the judicious choice of obstacle locations it is possible to generate mixing and enhanced heat transfer locally by impeding or partially blocking the fluid flow while maintaining a low pressure drop laminar flow elsewhere. Thus, a heat transfer device with high local heat transfer but relatively low pumping requirements is provided.

In some embodiments, said at least one obstruction extends across at least 30% of said at least one mini dimension.

The obstructions may take a number of forms and sizes. They should be sufficient to cause the required instabilities in the flow. Generally an obstacle that extends across at least 30% of the mini dimension is a suitable obstruction. In some cases it is preferable to have an obstacle that extends across between 30 and 80% of the mini dimension. In this regard although it may be desirable in some cases for the obstruction to extend across the whole conduit in other embodiments, it is preferable if the obstruction does not extend across the whole conduit as providing some sort of gap will reduce fouling of the obstruction.

The obstructions may come in a number of shapes but in some embodiments they comprise posts.

In some embodiments, said conduit has a substantially rectangular cross section, a smaller side of said rectangular cross section comprising said mini dimension.

Although the conduit may have a number of forms in some embodiments it has a slot-like rectangular shape with the smaller dimension being that of the mini dimension. In some embodiments the larger dimension of the rectangular shape is more than three times larger than the mini dimension. Generally the surface in closest thermal contact with the heat source will be the surface formed by the two dimensions other than the mini dimension as this provides a suitably large surface area for heat transfer. The dimensions of the surface area of the conduit in closest thermal contact to the heat source are in some embodiments at least 70% of those of the corresponding dimensions of the heat source. The sides of the conduit are in some embodiments straight to reduce resistance to flow.

In some embodiments, the heat transfer device further comprises a plurality of obstructions arranged at a plurality of predetermined location, said obstructions being configured to impede or partially block fluid flow and generate local instabilities in said fluid flow upstream of said obstructions thereby increasing heat transfer from said heat source at a plurality of locations upstream of said plurality of predetermined locations.

Although the heat transfer device may only have a single obstruction in some embodiments it will have several. In some embodiments these are arranged to correspond to points where hot spots are expected in the heat source.

In some embodiments the mini dimension is a micro dimension of less than 500 microns.

Providing one dimension that is a micro dimension of less than 500 microns, provides a heat transfer device with a low profile enabling it to be used to cool devices where their small size is important. Furthermore, this low dimension enables obstructions to cause instabilities at relatively low flow rates, providing a heat transfer device with low fluid and pumping requirements.

In some embodiments, said conduit comprises a single mini dimension, the other dimensions being larger and in some embodiments this single mini dimension is a single micro dimension.

As mentioned previously microchannels have a high resistance to flow and thus, providing a conduit with just one mini or micro dimension reduces this resistance to flow when compared to a microchannel, while still allowing laminar flow at relatively low flow rates and providing a device with a low profile and relatively high heat transfer.

In some embodiments, at least one of said at least one obstruction is thermally reactive and is operable to extend into said conduit increasing an obstruction to said fluid flow in response to an increase in temperature and to retract from an extended position in said conduit in response to a decrease in temperature.

Although previous embodiments have been particularly effective for topologies where the location of hot spots is both known and stable, for other cases where hot spots may be transient due to changes in data flow and processing requirements then a thermally reactive device which can provide increases in heat transfer locally in response to local temperature rises may be desirable. Given that the local increase in heat transfer is caused by the obstruction, a movable obstruction which can extend into the flow as temperatures increase and retract from it as they decrease is beneficial.

In some embodiments there may be a single thermally reactive obstruction, while in others there are a plurality of them each being activated in dependence on temperature local to that thermally reactive obstruction.

In some embodiments the channel may comprise both thermally reactive obstructions and passive obstructions. Such an arrangement may be desirable where a device has a component which generates heat for much of the time and thus, requires constant cooling which can be provided by the passive obstruction and yet it also comprises components which are only active periodically. Such components are most conveniently cooled using the thermally reactive obstructions which are triggered by the heat generated by the periodic activity of the component.

In some embodiments, said at least one obstruction is comprised of a thermally activated shape memory alloy.

One way of providing such a thermally reactive obstruction is to use a thermally activated shape memory alloy whose crystal shape changes in a reversible way with temperature, allowing it to extend into the flow at higher temperatures and retract from it at lower temperatures.

In some embodiments, said at least one obstruction comprises a thermally activated shape memory alloy flap mounted on a surface of said conduit and operable to bend away from said surface into said fluid flow in response to an increase in temperature of said obstruction and to retract from said fluid flow in response to a subsequent decrease in temperature.

One convenient way of providing such a thermally reactive obstruction is to use a thermally activated shape memory alloy flap, which flap lies parallel to a wall of the conduit at lower temperatures and extends away from the wall at higher temperatures.

In some embodiments, said at least one obstruction comprises nitinol.

Nitinol which is a nickel titanium alloy has shape memory properties and nitinol wire for example could be used to form thermally reactive obstructions.

Although the conduit maybe formed in a number of ways and from a number of substances, in some embodiments said conduit is formed in a silicon wafer.

Many electronic and communication devices that require cooling are small in size and maybe formed from silicon and as such forming the conduit in a silicon wafer allows the heat transfer device to be compatible with and formed close to the devices it seeks to cool.

In some embodiments, said heat transfer device further comprises a pressure reservoir comprising said viscoelastic fluid at a first pressure and a sink reservoir comprising said viscoelastic fluid at a second pressure, said second pressure being lower than said first pressure, said pressure and sink reservoirs being connected by said conduit, such that said viscoelastic fluid flows from said first pressure reservoir to said sink reservoir via said conduit.

In order for the fluid to flow through the conduit, some sort of pressure differential between the ends of the conduit should be provided and this may be provided by the use of reservoirs with some pumping mechanism maintaining a pressure difference between them.

A second aspect of the present invention provides a heat transfer device according to a first aspect of the present invention and at least one heat source in thermal contact with said heat transfer device, said heat source comprising at least one of a laser device and a processing device.

Embodiments of the present invention may be used to cool a number of devices, but owing to their compactness and their ability to provide localised cooling, they are particularly applicable to cooling processing devices and communication devices such as laser devices.

In some embodiments said mini dimension of said conduit is substantially perpendicular to a surface of said heat source.

Where the heat transfer device is in thermal contact with the heat source it is advantageous if the mini dimension is perpendicular to a surface of the heat source as in this case the thermal contact surface is the larger surface and the profile of the whole device is only increased by the size of the mini dimension.

A third aspect of the present invention provides, a method of transferring heat from a heat source comprising: arranging a conduit in thermal contact with said heat source, said conduit comprising at least one obstruction located adjacent to and downstream of at least one predicted hot spot on said heat source; flowing a viscoelastic fluid through said conduit, such that said at least one obstruction partially blocks flow of said viscoelastic fluid and generates local instabilities in said fluid flow upstream of said at least one obstruction thereby increasing heat transfer from said heat source at said predicted at least one hot spot.

A further aspect provides a heat transfer device said heat transfer device comprising: a conduit; a viscoelastic fluid operable to flow through said conduit and to transfer heat from a heat source in thermal contact with said conduit; said conduit comprising at least one thermally reactive obstruction arranged at a predetermined location; wherein said thermally reactive obstruction is operable to extend into said conduit in response to an increase in temperature and to retract from an extended position in response to a decrease in temperature, said obstruction being configured to partially block fluid flow when extending into said conduit and generate local instabilities in said fluid flow upstream of said obstruction thereby increasing heat transfer from said heat source at a location upstream of said predetermined location.

The use of viscoelastic fluids within conduits with thermally reactive obstructions is particularly effective for the cooling of electronic devices where a mini dimension for the conduit is desirable to reduce any impact on overall size. However, such devices are also applicable in larger dimension devices where the use of the thermally reactive obstructions can provide cooling of hot spots in devices where the topology of these hot spots may vary with time.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 illustrates a cross section through an exemplary heat transfer device according to an embodiment;
Figure 2 schematically shows a side view and plan view of an exemplary microgap conduit with a number of arrayed microposts;
Figure 3 shows a microgap conduit similar to that of Figure 2 but with thermally reactive obstructions; and
Figure 4 shows an exemplary heat transfer device with thermally reactive obstructions according to a further embodiment.

### DESCRIPTION OF THE EMBODIMENTS

Before discussing the embodiments in any more detail, first an overview will be provided.

Embodiments seek to exploit the properties of non-Newtonian viscoelastic fluids to generate local mixing within a flow geometry. Newtonian fluids like water can be given elastic properties by adding dilute amounts of long chain polymer or surfactants. In the presence of curved streamlines it is known that such flows exhibit secondary flows, in particular mixing. Such mixing is usually characteristic of higher flow rates occurring only after a critical value upon which the flow becomes turbulent throughout.

This mixing is responsible for a significant enhancement of the heat transfer properties of fluid flows as it provides a constant supply of cool fluid to the conduit wall and carries hot fluid away. However it comes with a drag penalty making it of limited use in many applications. This drag results from the diversion of the fluid's streamwise kinetic energy to the generation of mixing and since mixing occurs everywhere in the flow conduit the drag increase is very large.

Embodiments address this problem by making use of the unique behaviour of mixing in sub-critical viscoelastic flows. When the flow of a viscoelastic fluid is sheared (by pumping through a conduit the flow shears over the walls) the polymers in the fluid stretch like springs. When the flow is passed over an obstacle or around a bend which curves the streamlines these polymers release the elastic energy stored in them instigating mixing at this location only. Thereafter viscosity acts to damp the mixing and the flow returns to a laminar unperturbed state. Therefore it is possible to engineer geometries that will generate mixing and enhance heat transfer where desired locally, while maintaining a low pressure drop laminar flow everywhere else.

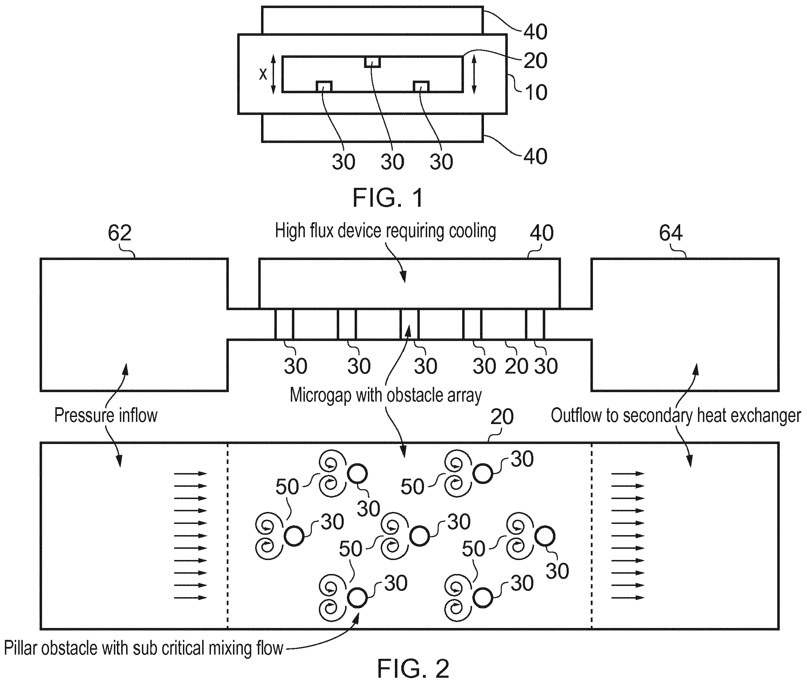

Figure 1 schematically shows a cross section through a conduit of a heat transfer device according to an embodiment. The conduit 20 is formed in a silicon wafer 10 on either side of which is mounted a heat source, in this case processors 40 that are to be cooled. Processors 40 form a stack of processors and the conduit of the heat transfer device flows between them extracting heat from each. Conduit 20 has a height x of 200 microns and a width and length similar to that of the processors it is cooling. The low height dimension enables laminar flow at a low flow rate and keeps the profile of the overall device small.

The conduit 20 has obstructions 30 extending from each of the upper and lower walls of the conduit towards the opposite side. These cause instabilities upstream of the obstructions 30 providing increased thermal transfer regions in these locations. In this embodiment the obstructions 30 do not extend across the whole conduit. The leaving of a gap helps reduce fouling and reduces the need to clean the conduit.

Figure 2 schematically shows a side view (upper figure) and a plan view (lower figure) of a microgap conduit 20 with a number of arrayed obstructions in the form of microposts 30. Viscoelastic fluid flowing through the conduit is forced around the posts and undergoes a transition to a mixing regime 50 as polymer chains in the flow release their stored energy. This mixing efficiently carries heat from local hot spots on the high flux device to a secondary heat exchanger (not shown) which cools the fluid prior to it being recirculated into the conduit on the left hand side. Careful design of the device locates the obstructions adjacent to the local hot sport regions on the high flux device.

The microgap conduit 20 of Figure 2 is arranged between a pressure reservoir 62 and a sink reservoir 64, with flow being from left to right. The high flux device 40 is in this embodiment a laser bar. The size of the microgap will depend on the geometry, however in the case of a laser bar the length will be approximately 1cm while the width and depth are approximately 2000 and 200µm respectively. When compared with a microconduit array the microgap has a larger cross-sectional area and a shorter length reducing pressure drop by reducing wetted area.

Within the microgap are arranged a number of micro posts 30 of order 50µm in diameter. These posts are placed in proximity to local hotspots in the package that require thermal management, such as discrete laser devices. When a viscoelastic fluid is pumped through the geometry it follows a straight flow path shearing the polymer chains which store energy. When the flow passes around the cylindrical obstacles 30 the streamlines are curved and the flow undergoes local mixing 50. Each post 30 contributes a step increase in the pressure drop across the microgap. Careful design of the geometry will allow heat transfer enhancement while minimising or at least reducing the pressure drop. This design is ideally suited to steady state cooling of local hotspots.

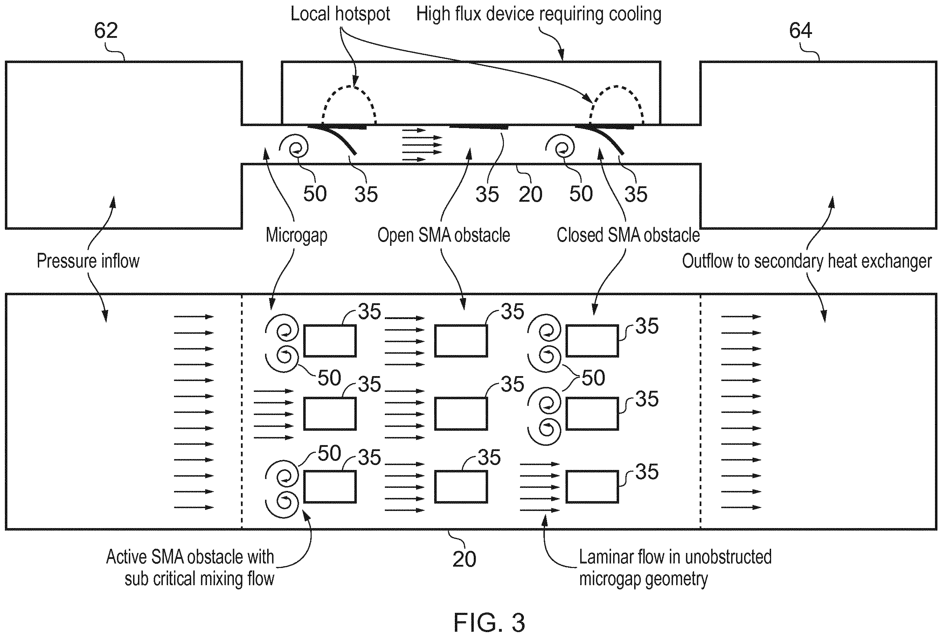

Figure 3 shows a schematic of a viscoelastic cooling geometry where thermally activated Shape Memory Alloy (SMA) flaps 35 are thermally driven to partially block the fluid flow locally. This generates local mixing 50 to dissipate the temporal heat load. The fluid pressure then returns the SMA flap 35 to its open positon when the flaps have cooled.

This embodiment is suited to transient cooling of hotspots where the hot spot topology varies with time. The arrangement corresponds to that of Figure 2 with the posts 30 of Figure 2 being replaced by thermally activated Shape Memory Alloy (SMA) flaps 35. Similar to the posts these SMA flaps 35 are strategically placed on the wall at the locations of known hot spots, although in this case these hot spots may be transient hot spots which may only periodically generate heat. The flaps 35 are treated to bend outwards obstructing the conduit when thermally activated. When there is no thermal load the SMA flaps 35 are retracted and their obstruction of the conduit 20 is reduced. When the flaps are retracted, flow through the microgap geometry is unhindered and laminar cooling is performed with minimal pressure drop. If necessary, a feedback loop allows the pump to reduce its operating point accordingly. Once a hot spot becomes active the SMA flap 35 bends outwards creating a flow obstacle. As with the microposts 30 of figure 2 local mixing 50 is initiated efficiently cooling the hot spot. This process is repeated as other hotspots are activated. Once the hot spot is no longer thermally reactive the fluid flow acts to help push the SMA flaps 35 back into place against the wall.

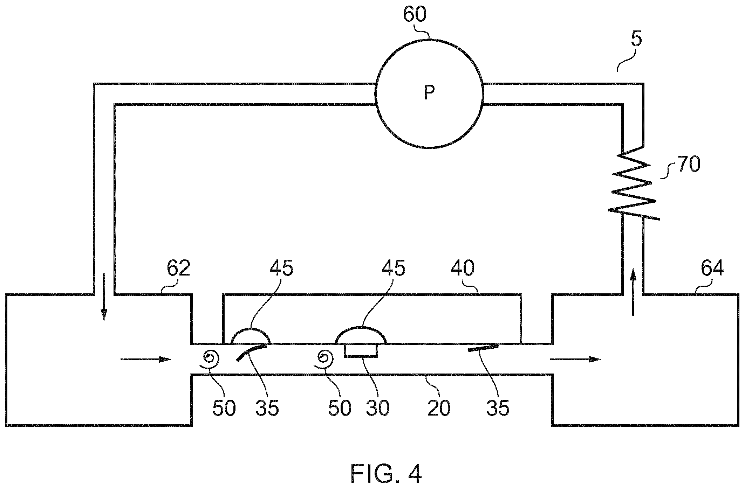

Figure 4 shows a further embodiment of a heat transfer device 5. The heat transfer device 5 is arranged to cool device 40. Heat transfer device 5 has a conduit 20 with a width of and height of 1 cm and a length of 3 cm. The conduit 20 is in thermal contact with device 40. Conduit 20 has thermally reactive obstructions 35 within it and a nonreactive obstruction 30. The thermally reactive obstructions 35 are activated by an increase in temperature caused by local heating 45 at device 40. Activation of these obstructions 35 causes them to move into the fluid flow. This obstructs the flow and causes local instabilities 50 in the flow providing increased local cooling of the device at these points. When the hot spot 45 has cooled the thermally reactive obstruction 35 will also cool and below a certain temperature will resume its position flush with the wall of the conduit. Obstruction 30 is not thermally reactive and provides a permanent obstruction and corresponding region of instability 50. In this embodiment device 40 has regions which are usually active and provide fairly constant hot spots and these are cooled with the permanent obstruction 30. Other hot spots are transient and these are cooled using the thermally reactive obstructions 35.

In this embodiment, there are reservoirs 62, 64 at either end of the conduit which contain the viscoelastic fluid and a pump 60 which pumps the fluid between the reservoirs via a heat exchanger 70. Heat exchanger 70 removes excess heat from the fluid which has been heated by device 40 while flowing through conduit 20.

In summary, embodiments provides a scalable, targeted and efficient mini or microfluidic thermal management solution for high heat flux applications thus enabling next generation telecoms and advanced electronic products. Mixing driven heat transfer allows greater heat fluxes to be dissipated allowing more devices to be integrated into smaller packages. It reduces pumping requirements therefore increasing overall system reliability and package size by reducing the complexity of the required pump and strength of the package fluidic seal. Unlike regular microconduit solutions the flow geometry may be tuned to increase local heat transfer or reduce local pressure drop.

Embodiments allow for targeted cooling of local hotspots while maintaining a low pressure drop. The best existing microconduit solutions lack this targeted approach and as such have not found their way into commercial use.

Embodiments have application in many thermal management applications beyond the telecoms industry where high fluxes and available space are moving in opposite directions.

Local hot spot cooling is a major challenge in many areas where macroscale overcooling of devices is often the only solution. Embodiments provide targeted cooling and could be used for cooling the various heat generating components of a CPU or GPU (such as floating point units, stream processors etc.) while limiting cooling of the less critical components such as caches.

It should be appreciated by those skilled in the art that any block diagrams herein represent conceptual views of illustrative circuitry embodying the principles of the invention.

## Claims

1. A heat transfer device, said heat transfer device comprising:
a conduit (20) having at least one mini dimension of less than 1 cm;
a viscoelastic fluid operable to flow through said conduit and to transfer heat from a heat source in thermal contact with said conduit;
said conduit (20) comprising at least one obstruction (30) each arranged at a predetermined location, said obstruction (30) being configured to partially block fluid flow and generate local instabilities in said fluid flow upstream of said obstruction thereby increasing heat transfer from said heat source at a location upstream of said predetermined location.

2. A heat transfer device according to claim 1, wherein said at least one obstruction (30) extends across at least 30% of said at least one mini dimension.

3. A heat transfer device according to any preceding claim, wherein said conduit has a substantially rectangular cross section, a smaller side of said rectangular cross section comprising said mini dimension.

4. A heat transfer device according to any preceding claim, said conduit (20) comprising a single mini dimension.

5. A heat transfer device according to any preceding claim, wherein said mini dimension comprises a micro dimension, said micro dimension being less than 500 microns.

6. A heat transfer device according to any preceding claim, comprising a plurality of obstructions (30) arranged at a plurality of respective predetermined locations, said obstructions being configured to partially block fluid flow and generate local instabilities (50) in said fluid flow upstream of said obstructions thereby increasing heat transfer from said heat source at a plurality of locations upstream of said plurality of predetermined locations.

7. A heat transfer device according to any preceding claim, wherein at least one of said at least one obstruction (35) is thermally reactive and is operable to extend into said conduit (20) increasing an obstruction to said fluid flow in response to an increase in temperature and to retract from an extended position in said conduit in response to a decrease in temperature.

8. A heat transfer device according to claim 7, wherein said at least one thermally reactive obstruction is comprised of a thermally activated shape memory alloy.

9. A heat transfer device according to claim 8, wherein said at least one thermally reactive obstruction (35) comprises a thermally activated shape memory alloy flap mounted on a surface of said conduit and operable to bend away from said surface into said fluid flow in response to an increase in temperature of said obstruction and to retract from said fluid flow in response to a subsequent decrease in temperature.

10. A heat transfer device according to any one of claim 7 to 9, wherein said at least one thermally reactive obstruction comprises nitinol.

11. A heat transfer device according to any preceding claim, wherein said conduit is formed in a silicon wafer.

12. A heat transfer device according to any preceding claim, said heat transfer device further comprising a pressure reservoir (62) comprising said viscoelastic fluid at a first pressure and a sink reservoir (64) comprising said viscoelastic fluid at a second pressure, said second pressure being lower than said first pressure, said pressure and sink reservoirs being connected by said conduit (20), such that said viscoelastic fluid flows from said first pressure reservoir to said sink reservoir via said conduit.

13. A heat transfer device according to any preceding claim and at least one heat source in thermal contact with said heat transfer device, said heat source comprising at least one of a laser device and a processing device.

14. A heat transfer device according to claim 13, wherein said mini dimension of said conduit is substantially perpendicular to a surface of said heat source.

15. A method of transferring heat from a heat source comprising:
arranging a conduit in thermal contact with said heat source, said conduit comprising at least one obstruction located adjacent to and downstream of at least one predicted hot spot on said heat source;
flowing a viscoelastic fluid through said conduit, such that said at least one obstruction partially blocks flow of said viscoelastic fluid and generates local instabilities in said fluid flow upstream of said at least one obstruction thereby increasing heat transfer from said heat source at said at least one predicted hot spot.

## Patentansprüche

1. Wärmeübertragungsvorrichtung, wobei besagte Wärmeübertragungsvorrichtung umfasst:
eine Leitung (20) mit mindestens einer Mini-Dimension von weniger als 1 cm;
ein viskoelastisches Fluid, das so betriebsfähig ist, dass es durch besagte Leitung fließt und Wärme von einer Wärmequelle in thermalem Kontakt mit besagter Leitung überträgt;
wobei besagte Leitung (20) mindestens ein Hindernis (30) umfasst, das jeweils an einer vorbestimmten Stelle angeordnet ist, wobei besagtes Hindernis (30) so konfiguriert ist, dass es den Fluidfluss teilweise blockiert und lokale Instabilitäten in besagtem Fluidfluss oberhalb von besagtem Hindernis erzeugt und dadurch die Wärmeübertragung von besagter Wärmequelle an einer Stelle oberhalb von besagter vorbestimmten Stelle erhöht.

2. Wärmeübertragungsvorrichtung nach Anspruch 1, wobei sich besagtes mindestens eine Hindernis (30) über mindestens 30 % von der mindestens einen Mini-Dimension erstreckt.

3. Wärmeübertragungsvorrichtung nach einem beliebigen der vorstehenden Ansprüche, wobei besagte Leitung einen im Wesentlichen rechteckigen Querschnitt aufweist und wobei eine kleinere Seite von besagtem rechteckigen Querschnitt besagte Mini-Dimension umfasst.

4. Wärmeübertragungsvorrichtung nach einem beliebigen der vorstehenden Ansprüche, wobei besagte Leitung (20) eine einzige Mini-Dimension umfasst.

5. Wärmeübertragungsvorrichtung nach einem beliebigen der vorstehenden Ansprüche, wobei besagte Mini-Dimension eine Mikro-Dimension umfasst und besagte Mikro-Dimension weniger als 500 Mikrometer beträgt

6. Wärmeübertragungsvorrichtung nach einem beliebigen der vorstehenden Ansprüche, umfassend eine Vielzahl von Hindernissen (30), die jeweils an einer Vielzahl von vorbestimmten Stellen angeordnet sind, wobei besagte Hindernisse so konfiguriert sind, dass sie den Fluidfluss teilweise blockieren und lokale Instabilitäten (50) in besagtem Fluidfluss oberhalb von besagten Hindernissen erzeugen und dadurch die Wärmeübertragung von besagter Wärmequelle an einer Vielzahl von Stellen oberhalb von besagter Vielzahl von vorbestimmten Stellen erhöhen.

7. Wärmeübertragungsvorrichtung nach einem beliebigen der vorstehenden Ansprüche, wobei mindestens eines von dem mindestens einen Hindernis (35) thermisch reaktiv ist und so betriebsfähig ist, dass es sich in besagte Leitung (20) erstreckt, um ein Hindernis für besagten Fluidfluss als Reaktion auf einen Temperaturanstieg zu erhöhen, und dass es sich von einer erweiterten Stelle in besagter Leitung als Reaktion auf einen Temperaturrückgang zurückzieht.

8. Wärmeübertragungsvorrichtung nach Anspruch 7, wobei das mindestens eine thermisch reaktive Hindernis eine thermisch aktivierte Formgedächtnislegierung umfasst.

9. Wärmeübertragungsvorrichtung nach Anspruch 8, wobei das mindestens eine thermisch reaktive Hindernis (35) eine thermisch aktivierte Formgedächtnislegierungsklappe umfasst, die auf einer Oberfläche von besagter Leitung angebracht ist und so betriebsfähig ist, dass sie sich als Reaktion auf einen Temperaturanstieg von besagter Oberfläche weg biegt in besagten Fluidfluss, und sich als Reaktion auf einen nachfolgenden Temperaturrückgang aus besagtem Fluidfluss zurückzieht.

10. Wärmeübertragungsvorrichtung nach einem der Ansprüche 7 bis 9, wobei das mindestens eine thermisch reaktive Hindernis Nitinol umfasst.

11. Wärmeübertragungsvorrichtung nach einem beliebigen der vorstehenden Ansprüche, wobei besagte Leitung aus einem Siliziumwafer gebildet ist.

12. Wärmeübertragungsvorrichtung nach einem beliebigen der vorstehenden Ansprüche, wobei besagte Wärmeübertragungsvorrichtung weiterhin einen Druckbehälter (62) umfasst, der besagtes viskoelastisches Fluidfluss bei einem ersten Druck umfasst, und einen Senkenbehälter (64), der besagtes viskoelastische Fluid bei einem zweiten Druck umfasst, wobei besagter zweiter Druck niedriger als besagter erster Druck ist und besagte Druck- und Senkenbehälter durch besagte Leitung (20) verbunden sind, sodass besagtes viskoelastisches Fluid über besagte Leitung von besagtem ersten Druckbehälter zu besagtem Senkenbehälter fließt.

13. Wärmeübertragungsvorrichtung nach einem beliebigen der vorstehenden Ansprüche und mit mindestens einer Wärmequelle in thermischem Kontakt mit besagter Wärmeübertragungsvorrichtung, wobei besagte Wärmequelle mindestens eine Laservorrichtung oder eine Verarbeitungsvorrichtung umfasst.

14. Wärmeübertragungsvorrichtung nach Anspruch 13, wobei besagte Mini-Dimension von besagter Leitung im Wesentlichen senkrecht zu einer Oberfläche von besagter Wärmequelle ist.

15. Verfahren zum Übertragen von Wärme von einer Wärmequelle, umfassend:
Anordnen einer Leitung in thermischem Kontakt mit besagter Wärmequelle, wobei besagte Leitung mindestens ein Hindernis umfasst, das sich angrenzend an mindestens einen erwarteten heißen Punkt auf besagter Wärmequelle und unterhalb desselben befindet;
Fließen eines viskoelastischen Fluids durch besagte Leitung, sodass besagtes mindestens eine Hindernis das besagte viskoelastische Fluid teilweise blockiert und lokale Instabilitäten in besagtem Fluidfluss oberhalb von dem mindestens einen Hindernis erzeugt und dadurch die Wärmeübertragung von besagter Wärmequelle an besagtem mindestens einen vorbestimmten heißen Punkt erhöht.

## Revendications

1. Dispositif de transfert de chaleur, ledit dispositif de transfert de chaleur comprenant ;
un conduit (20) ayant au moins une mini dimension inférieure à 1 cm ;
un fluide viscoélastique pouvant s'écouler à travers ledit conduit et permettant le transfert de chaleur à partir d'une source de chaleur en contact thermique avec ledit conduit ;
ledit conduit (20) comprenant au moins une obstruction (30), chaque obstruction étant disposée à un emplacement prédéterminé, ladite obstruction (30) étant configurée pour bloquer partiellement l'écoulement de fluide et générer des instabilités locales dans ledit écoulement de fluide en amont de ladite obstruction, augmentant ainsi le transfert de chaleur à partir de ladite source de chaleur à un emplacement en amont dudit emplacement prédéterminé.

2. Dispositif de transfert de chaleur selon la revendication 1, dans lequel ladite au moins une obstruction (30) s'étend sur au moins 30 % de ladite au moins une mini dimension.

3. Dispositif de transfert de chaleur selon l'une quelconque des revendications précédentes, dans lequel ledit conduit a une section transversale sensiblement rectangulaire, un côté plus court de ladite section transversale rectangulaire comprenant ladite mini dimension.

4. Dispositif de transfert de chaleur selon l'une quelconque des revendications précédentes, ledit conduit (20) comprenant une seule mini dimension.

5. Dispositif de transfert de chaleur selon l'une quelconque des revendications précédentes, dans lequel ladite mini dimension comprend une micro dimension, ladite micro dimension étant inférieure à 500 microns.

6. Dispositif de transfert de chaleur selon l'une quelconque des revendications précédentes, comprenant une pluralité d'obstructions (30) disposées à une pluralité d'emplacements prédéterminés respectifs, lesdites obstructions étant configurées pour bloquer partiellement l'écoulement de fluide et générer des instabilités locales (50) dans ledit écoulement de fluide en amont desdites obstructions, augmentant ainsi le transfert de chaleur à partir de ladite source de chaleur à une pluralité d'emplacements en amont de ladite pluralité d'emplacements prédéterminés.

7. Dispositif de transfert de chaleur selon l'une quelconque des revendications précédentes, dans lequel au moins une parmi ladite ou lesdites obstructions (35) est thermiquement réactive et permet de s'étendre dans ledit conduit (20), augmentant ainsi une obstruction audit écoulement de fluide en réponse à une augmentation de la température et pour se rétracter depuis une position étendue dans ledit conduit en réponse à une diminution de la température.

8. Dispositif de transfert de chaleur selon la revendication 7, dans lequel ladite au moins une obstruction thermiquement réactive est constituée d'un alliage à mémoire de forme thermiquement activé.

9. Dispositif de transfert de chaleur selon la revendication 8, dans lequel ladite au moins une obstruction thermiquement réactive (35) comprend un volet d'alliage à mémoire de forme thermiquement activé monté sur une surface dudit conduit et pouvant se déplier hors de ladite surface avec ledit écoulement de fluide en réponse à une augmentation de la température de ladite obstruction et se replier avec ledit écoulement de fluide en réponse à une diminution ultérieure de la température.

10. Dispositif de transfert de chaleur selon l'une quelconque des revendications 7 à 9, dans lequel ladite au moins une obstruction thermiquement réactive comprend du nitinol.

11. Dispositif de transfert de chaleur selon l'une quelconque des revendications précédentes, dans lequel ledit conduit est formé dans une plaque de silicium.

12. Dispositif de transfert de chaleur selon l'une quelconque des revendications précédentes, ledit dispositif de transfert de chaleur comprenant en outre un réservoir de pression (62) comprenant ledit fluide viscoélastique à une première pression et un réservoir de puits (64) comprenant ledit fluide viscoélastique à une deuxième pression, ladite deuxième pression étant inférieure à ladite première pression, ladite pression et les réservoirs de puits étant reliés par ledit conduit (20), de sorte que ledit fluide viscoélastique s'écoule à partir dudit premier réservoir de pression vers ledit réservoir de puits à travers ledit conduit.

13. Dispositif de transfert de chaleur selon l'une quelconque des revendications précédentes et au moins une source de chaleur en contact thermique avec ledit dispositif de transfert de chaleur, ladite source de chaleur comprenant un dispositif laser et/ou un dispositif de traitement.

14. Dispositif de transfert de chaleur selon la revendication 13, dans lequel ladite mini dimension dudit conduit est sensiblement perpendiculaire à une surface de ladite source de chaleur.

15. Procédé de transfert de chaleur à partir d'une source de chaleur comprenant :
la disposition d'un conduit en contact thermique avec ladite source de chaleur, ledit conduit comprenant au moins une obstruction située à côté d'au moins un point chaud prévu, et en aval de celui-ci, sur ladite source de chaleur ;
l'écoulement d'un fluide viscoélastique à travers ledit conduit, de sorte que ladite au moins une obstruction bloque partiellement l'écoulement dudit fluide viscoélastique et génère des instabilités locales dans ledit écoulement de fluide en amont de ladite au moins une obstruction, augmentant ainsi le transfert de chaleur à partir de ladite source de chaleur au niveau dudit au moins un point chaud prévu.
